# EUROPÄISCHE PATENTSCHRIFT

(11) **EP 1 086 337 B1**
(45) Veröffentlichungstag und Bekanntmachung des Hinweises auf die Patenterteilung: **06.08.2008**
(21) Anmeldenummer: 00910691.5
(22) Anmeldetag: 23.02.2000
(51) Int. Cl.: F21S 8/10, H05K 1/18

(54) **BEFEHLS- UND MELDEGERÄT ODER MELDEGERÄT MIT EINEM LEUCHTELEMENT**
CONTROL AND SIGNALING DEVICE OR SIGNALING DEVICE WITH A LUMINOUS ELEMENT
APPAREIL DE TRANSMISSION D'ORDRE ET DE SIGNALISATION OU APPAREIL DE SIGNALISATION A ELEMENT LUMINEUX

(30) Priorität: 27.02.1999 DE 19908574
(43) Veröffentlichungstag der Anmeldung: 28.03.2001
(73) Patentinhaber: Moeller GmbH, 53115 Bonn (DE)
(72) Erfinder: WOLFF, Bernd, D-53773 Hennef (DE); SCHÄFER, Jörg, D-53359 Rheinbach (DE); VOLBERG, Jürgen, D-53844 Troisdorf (DE); HÖGENER, Jürgen, D-53859 Niederkassel (DE)
(86) Internationale Anmeldenummer: PCT/EP2000/001462
(87) Internationale Veröffentlichungsnummer: WO 2000/052383

(56) Entgegenhaltungen:
- WO-A-97/42799
- FR-A- 2 576 719
- US-A- 5 253 144
- US-A- 5 684 667

## Beschreibung

Die Erfindung betrifft ein Befehls- und Meldegerät oder Meldegerät mit einem Leuchtelement.

Aus der DE 298 00 780 U1 ist ein Funktionselement für ein Meldegerät mit einem Leuchtelement gezeigt und beschrieben, wobei das Meldegerät aus einem Frontelement und einem Befestigungsadapter besteht, auf das die Funktionselemente einrastbar sind.

Das Funktionselement weist ein Leuchtmittel mit einer bajonettverschlußartigen Halterung auf. Als Leuchtmittel wird eine Glühlampe verwendet, die jedoch den Nachteil hat, daß ihre Lebensdauer im Vergleich zu anderen Leuchtmitteln, wie z.B. Leuchtdioden, geringer ist.

Das Isolierstoffgehäuse ist mit Leiterbahnen versehen, die mit Hilfe des Herstellungsverfahrens (Zweikomponentenspritzguß) der MID-Technologie angeordnet werden, wie in der DE 298 00780 U1 beschrieben ist.

Weiterhin ist es bekannt, Leiterbahnen durch das Heißprägeverfahren anzubringen, wie in dem Firmenprospekt 3-D MID e.V. Forschungsvereinigung "Räumliche Elektronische Baugruppen" 5/98, Seite 13. Eine vergleichbare Fundstelle zu der MID-Technik findet sich in der WO 97-42799 A1.

In Meldegeräten ist es bekannt, Leuchtdioden einzusetzen. Solche Geräte finden sich beispielsweise in folgenden Schriften: FR 2 576 719 A1, US 5 584 667.

Es ist von Nachteil, dass durch den komplexen Aufbau von Meldegeräten eine Mehrzahl von Fertigungsschritten vorzunehmen ist.

Aufgabe der Erfindung ist es, ein Befehls- und Meldegerät bzw. Meldegerät mit einem Funktionselement zu schaffen, das kostengünstig und einfach herzustellen ist.

Die Aufgabe der Erfindung wird durch die Merkmale des Anspruches 1 gelöst.

Anhand der Zeichnung, in der ein Ausführungsbeispiel dargestellt ist, sollen die Erfindung, weitere Ausgestaltungen und Verbesserungen der Erfindung und weitere Vorteile näher beschrieben und erläutert werden.

Es zeigt:
- Fig. 1: eine perspektivische Darstellung eines Funktionselementes mit nur einer Gehäusehälfte,
- Fig. 2: eine Darstellung des offenen Funktionselementes von oben,
- Fig. 3: eine Darstellung der Außenkontur des Leiterbahnenanordnung,
- Fig. 4: eine Darstellung der geprägten Leiterbahnen mit Restfolie,
- Fig. 5: eine Darstellung der Restfolie,
- Fig. 6: eine Darstellung der Leiterbahnen mit Bauteilen,
- Fig. 7: eine Darstellung des Gehäuses mit Folie und
- Fig. 8: eine Darstellung des im Gehäuse eingebauten LED-Elementes komplett mit allen Bauteilen.

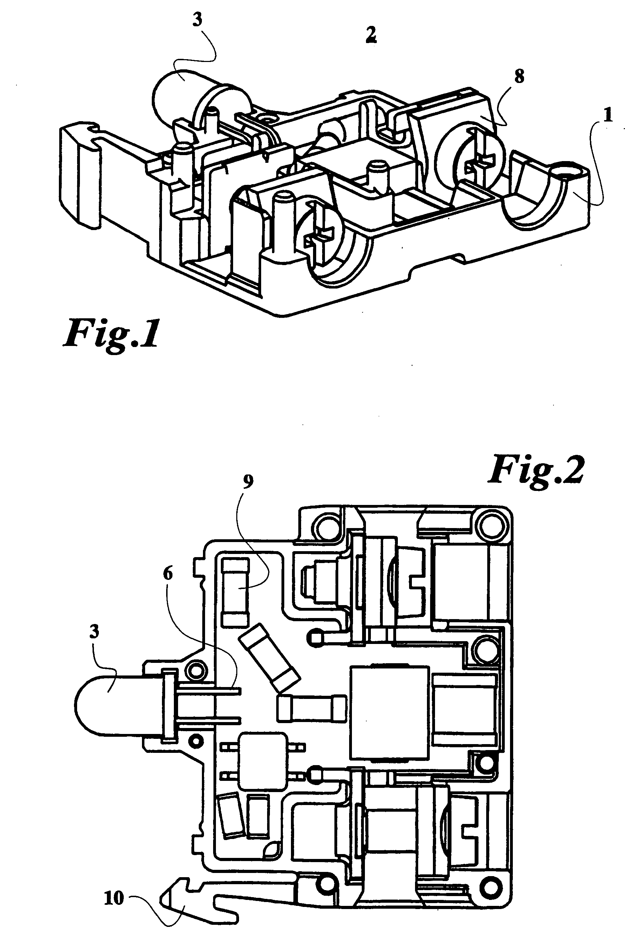

Die Fig. 1 zeigt eine Gehäusehälfte 1 des Funktionselementes 2 mit einer Leuchtdiode 3.
Das nicht vollständig gezeigte Befehls- und Meldegerät, das ein Leuchttaster sein kann, bzw. das Meldegerät, das eine Meldeleuchte sein kann, ist mit einem Leuchtelement versehen, bestehend aus einem Frontelement und einem Befestigungsadapter, auf das Funktionselemente 2 einrastbar sind.

Erfindungsgemäß ist nur eine Leuchtdiode 3 mit einem Leuchtdiodenkopf 5 und Anschlußdrähten 4 in einem Funktionselement 2 integriert, wobei der Leuchtdiodenkopf 5 in einer Aufnahme 6 eingebettet und gehalten ist, wobei die Leuchtdioden 3 einen Abstrahlungswinkel von 30-45 Grad aufweisen, und wobei die Leuchtdioden 3 eine Leuchtstärke von mindestens 0,5 candela aufweisen.

Durch den Abstrahlungswinkel von 30-45 Grad trifft Licht gebündelt auf die Innenfläche des Leuchtdiodenkopfes, was den Leuchtkopf besonders hell erscheinen läßt. Durch die Verwendung von Leuchtdioden 3 mit einer Leuchtstärke von mindestens 0,5 candela erreicht man eine sehr gute Ausleuchtung der Meldegeräte.
Die Farbwiedergabe ist deutlich besser als bei Glühlampen.

Das Funktionselement 2 weist weiterhin, wie in Fig. 1 dargestellt ist, Anschlußklemmen 8, eine elektronische Schaltung mit elektronischen Bauteilen 9, mindestens eine Rastnase 10 auf.

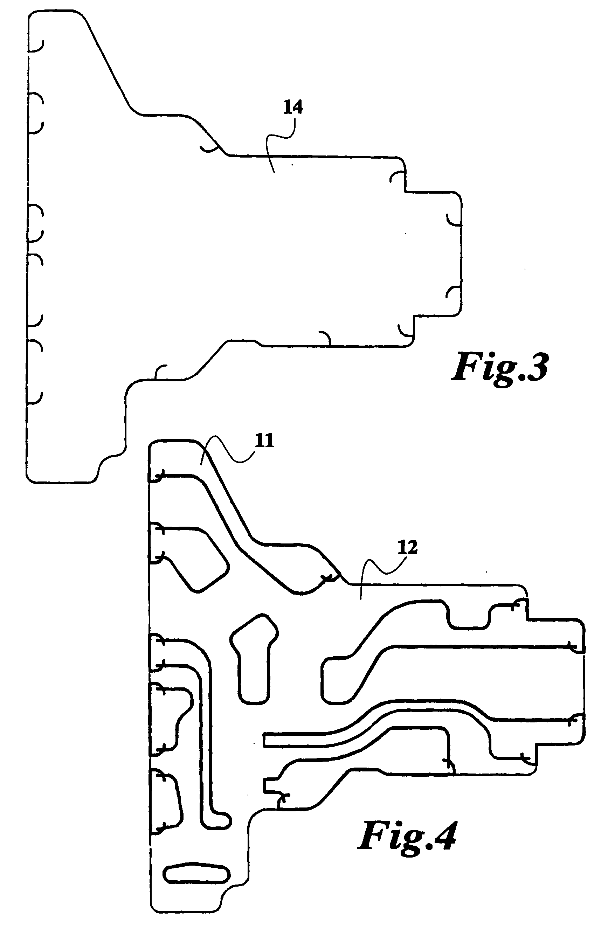

Die Figuren 3 bis 6 zeigen den Entstehungsvorgang der auf die Innenseite der Gehäusehälfte 1 angeordneten Leiterbahnen 11.
Das Verfahren wird als Heißprägen bezeichnet und ist in dem Prospekt "Forschungsvereinigung Räumliche Elektronische Baugruppen", 3-D MID e.V. näher beschrieben.

Zunächst wird, wie in der Fig. 3 gezeigt ist, eine Folie 14 aus elektrolytisch gewonnenem Kupfer aufgebracht, wobei die Folie 14 eine für die Gehäusehälfte 1 geeignete Außenkontur aufweist.

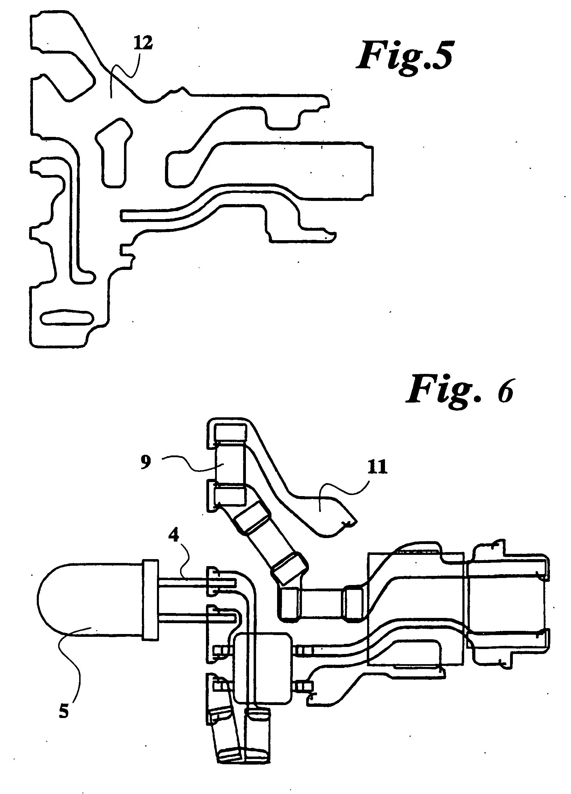

Anschließend werden die Leiterbahnen 11 mit der Restfolie 12 geprägt, wobei diese in der Fig. 4 dargestellt sind.
Nach dem Abziehen der Restfolie, die in Fig. 5 dargestellt ist, bleiben die Leiterbahnen 11 auf der Gehäusehälfte 1 angeordnet. Auf den Leiterbahnen 11 können elektronischen Bauelemente 9 angeordnet werden, wie in Fig. 6 dargestellt ist.

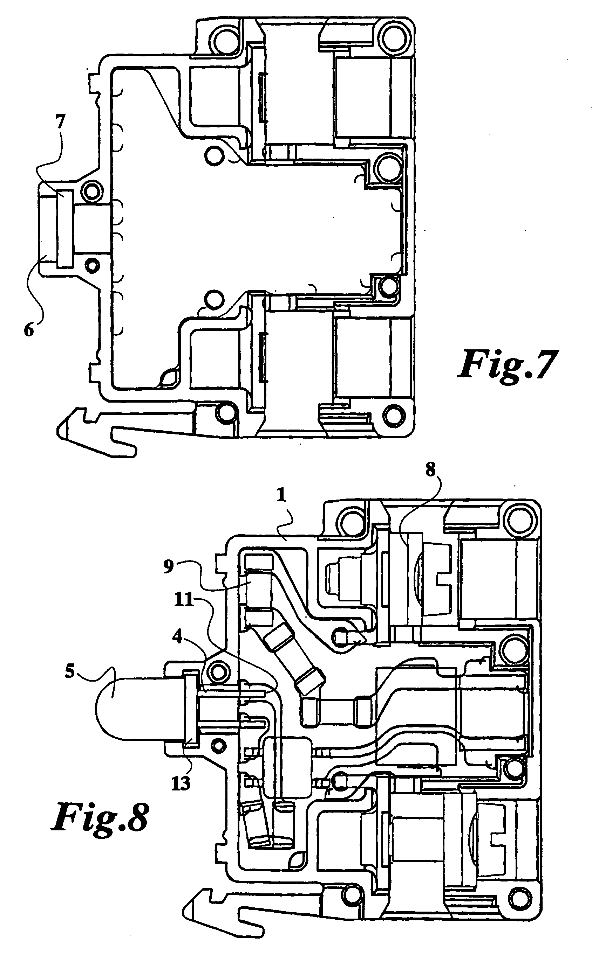

Wie in der Fig. 7 zu erkennen ist, ist im Bereich der Aufnahme 6 eine Halterille 7 vorhanden, in der die Leuchtdiode 3 durch einen Kragen 13 gehalten ist.

Damit die Leiterbahnen 11 beim Prägen in die Gehäusehälfte 1 von der Restfolie 12 getrennt werden, muß der Heißprägestempel im Prägebereich scharfkantig gestaltet sein. Die Restfolie 12 soll üblicherweise die Leiterbahnen 11 komplett umschließen. Diese Gestaltung gewährleistet, daß die Restfolie 12 nach dem Prägen gut aus der Gehäusehälfte entfernt werden kann und daß der Heißprägestempel beim Prägen immer auf die Folie trifft und nie die Gehäusehälfte 1 direkt berührt und damit verschmutzt wird.

Der Platz für die Leiterbahnen 11 wird vergrößert.

Um die Leiterbahnen 11 bis in die Ecken der Gehäusehälfte prägen zu können, werden an der Leiterbahnkontur im Außenbereich Radien angebracht. Die Restfolie braucht in diesem Bereich nicht mehr die Leiterbahnen 11 umschließen! Der Prägestempel steht gegenüber der Außenkontur der Leiterbahnen 11 etwas zurück, so daß das Berühren der Gehäusehälfte 1 verhindert wird.

Um das Lösen der Restfolie 12 weiter zu optimieren, kann die Folie 14 vor dem Prägen Einschnitte z. B. in Form von Viertelkreisen erhalten (siehe Figur 3). Diese Einschnitte liegen genau im Übergang zwischen scharfkantigem und abgerundetem Bereich des Prägestempels und schneiden sich mit der Prägekontur (siehe Fig. 4)

### Liste der Bezugszeichen

Gehäusehälfte 1
Funktionslementes 2
Leuchtdiode 3
Anschlußdrähten 4
Leuchtdiodenkopf 5
Aufnahme 6
Halterille 7
Anschlußklemmen 8
elektronische Bauteilen 9
Rastnase 10
Leiterbahnen 11
Restfolie 12
Kragen 13
Folie 14

## Patentansprüche

1. Mit einem Leuchtelement ausgestattetes Funktionselement zum Einrasten in einem Befestigungsadapter eines weiterhin ein Frontelement aufweisenden Befehls- und Meldegerätes oder Meldegerätes,
- wobei eine Gehäusehälfte (1) des Funktionselementes (2) auf der Innenseite mit dem Leuchtelement und Anschlußklemmen (8) verbundene und nach einem MID-Verfahren erzeugte Leiterbahnen (11) aufweist,
**dadurch gekennzeichnet, daß**
- das Leuchtelement in Form einer mit Leuchtdiodenkopf (5) und Anschlussdrähten (4) ausgestatteten Leuchtdiode (3) in dem Funktionselement (2) integriert ist,
- der Leuchtdiodenkopf (5) wenigstens in einer Aufnahme (6) der Gehäusehälfte (1) eingebettet und gehalten ist,
- die Leuchtdiode (3) einen Abstrahlungswinkel von 30-45 Grad und eine Leuchtstärke von mindestens 0,5 Candela aufweist und
- die Leiterbahnen (11) durch Heißprägen aus einer Folie (14) aufgebracht sind,
- wobei die Folie (14) eine für die Innenseite der Gehäusehälfte (1) geeignete Außenkontur aufweist.

2. Funktionselement nach Anspruch 1, **dadurch gekennzeichnet, daß** die Außenkontur der Leiterbahnenanordnung so gestaltet ist, dass durch die nach dem Heißprägen zu entfernenden Restfolie (12) alle Leiterbahnen (11) komplett umschlossen sind.

3. Funktionselement nach Anspruch 1, **dadurch gekennzeichnet, daß** bis an Innenkanten der Gehäusehälfte (1) reichende Teile der Leiterbahnen (11) nach außen tretende Radien ausgebildet sind.

4. Funktionselement nach vorstehendem Anspruch, **dadurch gekennzeichnet, daß** die nach außen tretenden Radien als vorgeschnittene Viertelkreise ausgebildet sind.

5. Funktionselement nach Anspruch 1, **dadurch gekennzeichnet, daß** im Bereich der Aufnahme (6) eine Halterille (7) vorhanden ist, in der die Leuchtdiode (3) durch einen Kragen (13) gehalten ist.

6. Funktionselement nach Anspruch 1, **dadurch gekennzeichnet, daß** auf den Leiterbahnen (11) elektronische Bauelemente (9) angeordnet sind.

7. Funktionselement nach Anspruch 1, **dadurch gekennzeichnet, daß** das Funktionselement (2) mindestens eine Rastnase (10) aufweist.

## Claims

1. A functional element provided with a light-emitting element for engagement in a mounting adapter of a control and signalling unit or signalling unit additionally comprising a front element,
- a housing half (1) of the functional element (2) comprising on the inside conductor tracks (11) connected to the light-emitting element and terminals (8) and produced using an MID method
**characterised in that**
- the light-emitting element in the form of a light-emitting diode (3) provided with a light-emitting diode head (5) and leads (4) is integrated into the functional element (2),
- the light-emitting diode head (5) is embedded and held at least in a receptacle (6) of the housing half (1),
- the light-emitting diode (3) has an angle of radiation of 30-45 degrees and a luminous intensity of at least 0.5 candelas and
- the conductor tracks (11) are applied by hot stamping from a foil (14),
- the foil (14) having an outer contour suitable for the inside of the housing half (1).

2. A functional element according to claim 1, **characterised in that** the outer contour of the conductor track arrangement is so designed that all the conductor tracks (11) are completely surrounded by the residual foil (12) to be removed after the hot stamping.

3. A functional element according to claim 1, **characterised in that** parts of the conductor tracks (11) reaching as far as inside edges of the housing half (1) are formed as outwardly extending radii.

4. A functional element according to the preceding claim, **characterised in that** the outwardly extending radii take the form of precut quarter-circles.

5. A functional element according to claim 1, **characterised in that** a retaining slot (7) is provided in the area of the receptacle (6), in which retaining slot (7) the light-emitting diode (3) is held by a collar (13).

6. A functional element according to claim 1, **characterised in that** electronic components (9) are arranged on the conductor tracks (11).

7. A functional element according to claim 1, **characterised in that** the functional element (2) comprises at least one latching lug (10).

## Revendications

1. Elément fonctionnel pourvu d'un élément lumineux, destiné à être encliqueté dans un adaptateur de fixation d'un appareil de transmission d'ordre et de signalisation ou appareil de signalisation comprenant en outre un élément frontal,
- une moitié de boîtier (1) de l'élément fonctionnel (2) étant pourvu, sur le côté intérieur, de pistes conductrices (11) reliées à l'élément lumineux et à des bornes de connexion (8) et produites selon un procédé MID,
**caractérisé par le fait que**
- l'élément lumineux est intégré dans l'élément fonctionnel (2) sous forme d'une diode lumineuse (3) pourvue d'une tête de diode lumineuse (5) et de fils de connexion (4),
- la tête de diode lumineuse (5) est insérée et maintenue au moins dans un logement (6) de la moitié de boîtier (1),
- la diode lumineuse (3) a un angle de réflexion entre 30 et 45 degrés et une intensité lumineuse d'au moins 0,5 Candela et
- les pistes conductrices (11) sont appliquées par estampage à chaud d'une feuille (14),
- la feuille (14) ayant un contour extérieur adapté au côté intérieur de la moitié de boîtier (1).

2. Elément fonctionnel selon la revendication 1, **caractérisé par le fait que** le contour extérieur de l'agencement de pistes conductrices est formé de manière à ce que toutes les pistes conductrices (11) soient complètement entourées par la feuille résiduelle (12) à enlever après l'estampage à chaud.

3. Elément fonctionnel selon la revendication 1, **caractérisé par le fait que** les parties des pistes conductrices (11) arrivant jusqu'aux bords intérieurs de la moitié de boîtier (1) sont formées en tant que rayons saillant vers l'extérieur.

4. Elément fonctionnel selon la revendication précédente, **caractérisé par le fait que** les rayons saillant vers l'extérieur sont formés en tant que quarts de cercle prédécoupés.

5. Elément fonctionnel selon la revendication 1, **caractérisé par** la présence dans la zone du logement (6) d'une rainure de retenue (7) dans laquelle la diode lumineuse (3) est retenue par un collet (13).

6. Elément fonctionnel selon la revendication 1, **caractérisé par le fait que** des composants électroniques (9) sont agencés sur les pistes conductrices (11).

7. Elément fonctionnel selon la revendication 1, **caractérisé par le fait que** l'élément fonctionnel (2) est pourvu d'au moins un ergot d'encliquetage (10).
